# EUROPÄISCHE PATENTSCHRIFT

(11) **EP 1 047 923 B1**
(45) Veröffentlichungstag und Bekanntmachung des Hinweises auf die Patenterteilung: **12.12.2001**
(21) Anmeldenummer: 99915627.6
(22) Anmeldetag: 16.03.1999
(51) Int. Cl.: G01K 7/18, H01C 17/00

(54) **SENSORBAUELEMENT**
SENSOR COMPONENT
COMPOSANT DETECTEUR

(30) Priorität: 26.03.1998 DE 19813468
(43) Veröffentlichungstag der Anmeldung: 02.11.2000
(73) Patentinhaber: SENSOTHERM TEMPERATURSENSORIK GmbH, 90441 Nürnberg (DE)
(72) Erfinder: ZITZMANN, Heinrich, D-91207 Lauf (DE)
(74) Vertreter: Schoppe, Fritz, Dipl.-Ing.
(86) Internationale Anmeldenummer: EP9901723
(87) Internationale Veröffentlichungsnummer: WO9949285

(56) Entgegenhaltungen:
- FR-A- 2 475 724
- US-A- 3 568 127
- US-A- 4 649 364
- PATENT ABSTRACTS OF JAPAN vol. 017, no. 445 (P-1593), 16. August 1993 (1993-08-16) -& JP 05 099758 A (MURATA MFG CO LTD), 23. April 1993 (1993-04-23)

## Beschreibung

Die vorliegende Erfindung bezieht sich auf Sensorbauelemente und insbesondere auf Sensorbauelemente mit einer verbesserten und zuverlässigeren Kontaktanordnung zwischen dem Sensor und daran angebrachten Anschlußdrähten.

Sensorbauelemente werden gegenwärtig beispielsweise als Temperatursensoren oder auch als Luft- bzw. Gasflußsensoren verwendet. Bei einer Temperaturerfassung werden beispielsweise Platintemperatursensorbauelemente eingesetzt, um die Umgebungstemperatur zu bestimmen. Die Funktionsweise eines Platintemperatursensorbauelements besteht darin, daß eine Temperaturänderung in der Umgebung des Platintemperatursensorbauelements eine Widerstandsänderung in einem in dem Bauelement angeordneten Platinfilm hervorruft. Diese Widerstandsänderung kann von einer Meßschaltung erfaßt und bezüglich der Umgebungstemperatur ausgewertet werden, so daß die Temperatur der Umgebung, in der das Platintemperatursensorbauelement angeordnet ist, bestimmt werden kann.

Ein herkömmliches Platintemperatursensorbauelement ist in den Figuren 5a und 5b dargestellt. Auf einem Trägermaterial 2 aus einem Keramikmaterial, z. B. Al₂O₃-Keramik, ist ein strukturierter Platinfilm 4 aufgebracht. In einem Anschluß-bzw. Kontaktbereich sind zwei Anschlußdrähte 6 mit dem Platinfilm 4 elektrisch verbunden. In dem Kontaktbereich ist über den Anschlußdrähten 6 und über dem Platinfilm 4 eine Fixierungsglasur 8 aufgebracht. Außerhalb des Kontaktbereichs ist der Platinfilm 4 mit einer Glaspassivierungsschicht 10 überzogen, um den Platinfilm 4 vor Umgebungseinflüssen zu schützen. Die Fixierungsglasur 8 ist vorgesehen, um durch diese über dem Kontaktbereich aufgebrachte Glasurmasse eine mechanische Fixierung der Anschlußdrähte 6 an dem Sensorbauelement zu erreichen.

Dieser Aufbau stellt für viele Anwendungen eine ausreichend gute und zuverlässige Kontaktqualität bereit. Für sehr schwierige Anwendungen mit hohen mechanischen, thermischen und chemischen Belastungen für das Sensorbauelement weist diese Anordnung jedoch beträchtliche Einschränkungen auf.

Die Kontaktqualität zwischen den Anschlußdrähten 6 und dem Sensorbauelement wird wesentlich von der Haftung des Platinfilms 4 an dem Keramikträger 2 bestimmt. Die ursprünglich ausreichende Haftung des Platinfilms 4 kann jedoch z. B. aufgrund von geringfügig unterschiedlichen thermischen Ausdehnungskoeffizienten des Keramikmaterials (z. B. Al₂O₃-Keramik) und Platin durch häufige und extreme Temperaturwechsel (20°C bis 800°C) sowie durch gleichzeitig auftretende äußere mechanische Verspannungen oder Belastungen bzw. durch eine aggressive chemische Athmosphärenumgebung deutlich herabgesetzt werden oder sogar verloren gehen. Wenn die Sensorbauelemente über eine sehr lange Zeitdauer (z. B. Monate, Jahre) widrigen Bedingungen ausgesetzt werden, kann dies dazu führen, daß in dem Kontaktbereich zwischen den Anschlußdrähten 6 und dem Platinfilm 4 sowohl elektrische als auch mechanische Kontaktprobleme auftreten.

Da die Sensorbauelemente in der praktischen Anwendung häufig sehr harten mechanischen, thermischen sowie auch chemischen Belastungen ausgesetzt sind, wirken sich diese hohen Belastungen im allgemeinen sowohl auf den eigentlichen sensitiven Bereich, als auch insbesondere auf die Kontaktzone der nach außen führenden elektrischen Anschlüsse aus.

Da die einzelnen Schichten eines herkömmlichen Platintemperaturbauelementes übereinander mit offenen seitlichen Trennschichten angeordnet sind, können außerdem störende Umwelteinflüsse seitlich auf die freiliegenden einzelnen Kanten der übereinander angeordneten Schichten einwirken. Dies kann über einen längeren Zeitraum sowohl zu einer Beschädung der Platinschicht als auch zu einer Ablösung der Platinschicht von dem Keramikkörper oder der Glaspassivierungsschicht führen.

Ferner wird häufig über die Anschlußdrähte eine mechanische Beanspruchung auf den Kontaktbereich ausgeübt. Die auf den Kontaktbereich einwirkenden mechanischen Kräfte können dazu führen, daß eine bereits angegriffene mechanische Verbindung zwischen den einzelnen Schichten unter Umständen weiter beeinträchtigt wird, was zu einer noch stärkeren Beschädigung oder im schlimmsten Fall zu einer Zerstörung des Sensorbauelements führen kann. In jedem Fall wird sich jedoch die Lebensdauer des Sensorbauelements deutlich verkürzen, wobei auch eine Beeinflussung oder Verfälschung der erfaßten Meßergebnisse auftreten kann, wenn das Sensorbauelement eine Beschädigung aufweist.

Die JP 06-137959 A beschreibt einen Platintemperatursensor, bei dem ein Verlängerungsanschlüßleitungsdraht und eine Verbindungsstelle desselben zu einem Hauptanschlußleitungsdraht davor geschützt werden sollen, aufgrund einer Biegung zu brechen, indem die Verbindungsstelle mit einem Isolator, der eine bestimmte Festigkeit aufweist, bedeckt wird, während der Verlängerungsanschlußleitungsdraht mit einem flexiblen Überzug bedeckt wird.

Ausgehend von diesem Stand der Technik liegt der vorliegenden Erfindung die Aufgabe zugrunde, ein Sensorbauelement mit einer zuverlässigeren und widerstandsfähigeren Kontaktanordnung zu schaffen.

Diese Aufgabe der vorliegenden Erfindung wird durch ein Sensorbauelement gemäß Anspruch 1 und durch ein Verfahren zum Herstellen eines Sensorbauelements gemäß Anspruch 8 erfüllt.

Das Sensorbauelement der vorliegenden Erfindung weist einen Keramikträger, einen Metallfilm, der auf dem Keramikträger aufgebracht ist, zumindest einen Anschlußdraht, der in einem Kontaktbereich mit dem Metallfilm elektrisch verbunden ist, und eine Fixierungsglasur auf, die in dem Kontaktbereich über dem Metallfilm und dem zumindest einem Anschlußdraht aufgebracht ist, wobei der Keramikträger des Sensorbauelements im Bereich der Fixierungsglasur zumindest eine Vertiefung aufweist.

Die vorliegende Erfindung schafft ferner ein Verfahren zum Herstellen eines Sensorbauelements, das folgende Schritte aufweist: Aufbringen eines Metallfilms auf einen Keramikträger, Vorsehen von zumindest einer Vertiefung in dem Keramikträger, elektrisches Verbinden des Metallfilms mit zumindest einem Anschlußdraht in einem Kontaktbereich, Aufbringen einer Fixierungsglasurmasse in dem Kontaktbereich über dem Anschlußdraht, dem Metallfilm und der zumindest einen Vertiefung, und Verschmelzen der Fixierungsglasurmasse mit dem Keramikträger.

Der vorliegenden Erfindung liegt die Erkenntnis zugrunde, daß die Kontaktqualität zwischen dem Sensorbauelement und den Zuleitungsdrähten deutlich verbessert werden kann, indem die Fixierungsglasur eine zusätzliche mechanische Verzahnung mit dem Keramikträger erhält. Diese zusätzliche mechanische Verzahnung wird erreicht, indem während der Herstellung des Sensorbauelements Vertiefungen in dem Keramikträger vorgesehen werden, wobei an diesen Stellen gleichzeitig auch der Metallfilm entfernt wird. Diese Gräben werden daraufhin mit einer geeigneten Glasmasse aufgefüllt. Nachdem die Anschlußdrähte an den vorgesehenen Kontaktflächen angebondet worden sind, wird dieser Kontaktbereich mit einer Fixierungsglasurmasse umgeben und bei einer hohen Temperatur aufgeschmolzen. Die Fixierungsglasurmasse verschmilzt hierbei zusätzlich zu der Verbindung mit dem Platinfilm auch mit der in den Vertiefungen seitlich daneben angeordneten Glasmasse. Die Glasmasse kann sowohl durch die Fixierungsglasurmasse selbst in den Vertiefungen gebildet sein oder vor dem Verschmelzen getrennt in den Vertiefungen aufgebracht werden, wobei durch das Verschmelzen der Fixierungsglasur mit dem Substratträger eine einheitliche und dauerhafte Fixierung der Anschlußdrähte im Kontaktbereich des Sensorbauelements erreicht wird. Die Vertiefungen in dem Keramikmaterial können außerdem auch an der Vorderseite, an der die Anschlußdrähte aus dem Kontaktbereich heraustreten, angeordnet sein.

Ein Vorteil der vorliegenden Erfindung besteht darin, daß durch die Verzahnung zwischen der Fixierungsglasurmasse und dem Keramikträger eine erheblich bessere mechanische Stabilität der Kontaktierung der Anschlußdrähte mit den Anschlußflächen des Metallfilms im Kontaktbereich des Sensorbauelements erreicht wird.

Ein weiterer Vorteil der vorliegenden Erfindung besteht darin, daß an der ansonsten offenen seitlichen Trennfläche durch die erfindungsgemäße Anordnung des Sensorbauelements der Metallfilm vollständig bzw. hermetisch gegen aggressive Umgebungseinflüsse, wie beispielsweise gegen eine aggressive chemische Athmosphäre, abgeschirmt wird, wodurch eine Ablösung der Metallschicht von dem Substratträger unterbunden wird.

Ein weiterer Vorteil der vorliegenden Erfindung besteht darin, daß eine Lockerung der Haftung zwischen dem Metallfilm und dem Keramikträger verhindert wird, wodurch ferner die Kontaktqualität zwischen dem Metallfilm und den Anschlußdrähten entscheidend verbessert wird. Durch diese Maßnahmen kann auch unter äußerst harten Umgebungsbedingungen eine erhöhte Lebensdauer des Sensorbauelements erreicht werden.

Bevorzugte Weiterbildungen der vorliegenden Erfindung sind in den Unteransprüchen definiert.

Bevorzugte Ausführungsbeispiele der vorliegenden Erfindung werden nachfolgend unter Bezugnahme auf die beiliegenden Zeichnungen näher erläutert. Es zeigen:
- Figur 1a und 1b: eine Rück- bzw. Seitenansicht eines Sensorbauelements gemäß einem Ausführungsbeispiel der vorliegenden Erfindung;
- Figur 2: eine Schnittansicht einer Weiterbildung des erfindungsgemäßen Sensorbauelements;
- Figur 3: eine Ansicht des Kontaktbereichs des Sensorbauelements mit einer alternativen Ausgestaltung der Enden der Anschlußdrähte;
- Figur 4: eine rückseitige Ansicht einer Sensorbauelementreihe während der Fertigung;
- Figur 5a und 5b: einen im Stand der Technik bekannten Platintemperatursensor.

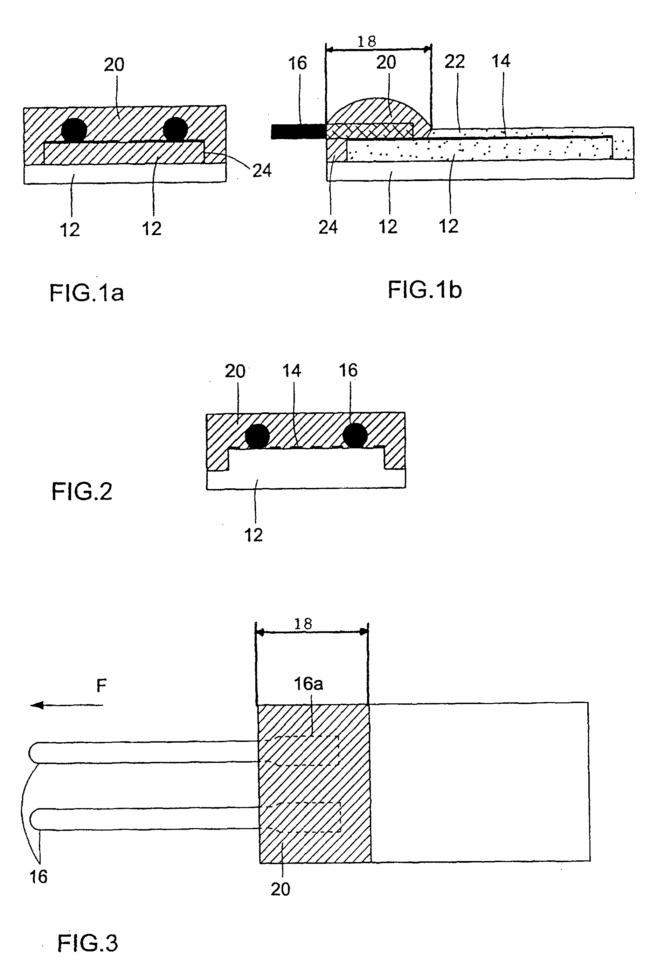

Anhand von Fig. 1a und 1b wird nun ein bevorzugtes Ausführungsbeispiel des erfindungsgemäßen Sensorbauelements näher beschrieben.

Das Sensorbauelement weist einen Keramikträger 12 auf, auf dem ein Metallfilm 14 aufgebracht ist. Bei diesem Ausführungsbeispiel sind zwei Anschlußdrähte 16 in einem Kontaktbereich 18 jeweils mit einer Kontaktfläche des Metallfilms 14 elektrisch verbunden. In dem Kontaktbereich 18 ist über dem Metallfilm 14 und den Anschlußdrähten 16 eine Fixierungsglasur 20 aufgebracht. Über dem Bereich des Metallfilms 14, der sich außerhalb des Kontaktbereichs 18 befindet, ist eine Glaspassivierungsschicht 22 aufgebracht. Der Keramikträger 12 weist um seinen gesamten Umfang eine Vertiefung bzw. Stufung 24 auf. Diese Vertiefung 24 ist mit einer Glasmasse gefüllt, die durch Verschmelzen sowohl mit dem Keramikträger 12 als auch mit der Fixierungsglasur 20 fest verbunden ist.

Wie aus den Figuren 1a und 1b zu erkennen ist, ist die Stufung bzw. die Vertiefung 24 in dem Keramikträger auch an der Vorderseite, das heißt an der Seite, an der die Anschlußdrähte 16 aus dem Kontaktbereich heraustreten, angeordnet.

Somit ist sichergestellt, daß an den Seiten des Sensorbauelements keine freiliegenden Kanten vorhanden sind, die aggressiven Umgebungseinflüssen ausgesetzt sein könnten.

Wie aus den Fig. 1a und 1b deutlich wird, ist die Fixierungsglasur 20 im Gegensatz zu einem im Stand der Technik bekannten Sensorbauelement im Kontaktbereich 18 nicht nur über den Anschlußflächen des Metallfilms 14 und den Anschlußdrähten 16 aufgebracht, sondern außerdem durch die Verschmelzung der Fixierungsglasur 20 fest mit der in den Vertiefungen 24 angeordneten Glasmasse und damit auch mit dem Keramikträger 12 fest verbunden. Somit wird durch diese Anordnung des Kontaktbereichs 18 eine zusätzliche mechanische Verzahnung der Fixierungsglasur 20 mit dem Keramikträger 12 bereitgestellt.

Das Material für den auf dem Keramikträger 12 aufgebrachten Metallfilm 14 kann beispielsweise Platin, Nickel oder ein anderes geeignetes Metall oder eine geeignete Metallegierung sein, wobei das Keramikmaterial für den Keramikträger 12 ein Al₂O₃-Keramikmaterial, ein MgTiO₃-Keramikmaterial oder ein anderes geeignetes Keramikmaterial sein kann.

Neben der durch die Stufung erreichten wesentlich besseren mechanischen Verzahnung zwischen der Glasurmasse und dem Keramikträger 12, liefert diese Anordnung ferner eine hermetische Abschirmung des Metallfilms 14 gegen eine aggressive chemische Athmosphäre an der sonst offenen seitlichen Trennfläche. Eine Lockerung der Haftung zwischen dem Metallfilm 14 und dem Keramikträger 12 wird durch die oben erwähnte Anordnung wirkungsvoll verhindert, wobei durch die mechanische Verzahnung.der Fixierungsglasur 20 mit dem Keramikträger 12 die Kontaktqualität entscheidend verbessert wird. Dies führt zu einer erhöhten Lebensdauer des Sensorbauelements auch unter aggressiven Umgebungsbedingungen.

In Figur 2 ist eine weitere Ausgestaltung der Kontaktfläche des Metallfilms 14 im Kontaktbereich 18 des Sensorbauelements dargestellt. Der Metallfilm 14 weist im Bereich der Kontaktflächen eine kammartige Struktur auf, in der zwischen den Metallfilmabschnitten Keramikträgerbereiche freigelegt sind. Die freigelegten Keramikträgerbereiche sind durch Verschmelzen fest mit der Fixierungsglasur 20 verbunden. Durch diese Ausführungsform läßt sich insbesondere bei größeren Kontaktflächen die Gesamthaftung zwischen dem Keramikträger 12 und dem strukturierten Metallfilm 14 verbessern, da ein relativ großer Bereich des Keramikträgers direkt mit der Fixierungsglasur 20 verbunden ist.

Diese kammartige Metallfilmstruktur kann durch ein bereichsweises Entfernen des Metallfilms 14, beispielsweise durch eine Laserbestrahlung oder durch Plasmaätzen, erreicht werden. Da bei dieser Anordnung die Fixierungsglasur 20 direkt und in einem relativ großen Bereich mit dem Keramikträger 12 verschmolzen ist, wird die zusätzliche mechanische Verzahnung der Fixierungsglasur 20 mit dem Keramikträger 12 nochmals gesteigert. Somit wird eine Lockerung oder sogar eine Ablösung des Metallfilms 14 von dem Keramikträger 12 wirkungsvoll unterbunden.

In Figur 3 ist eine Ausgestaltung der Anschlußdrahtenden 16a in dem Kontaktbereich 18 innerhalb der Fixierungsglasur 20 dargestellt. Die Form der Anschlußdrahtenden 16a ist in dem Kontaktbereich innerhalb der Fixierungsglasur 20 etwas verbreitert. Durch diese Ausführungsform der Anschlußdrahtenden 16a läßt sich die mechanische Auszugskraft F der Anschlußdrähte erhöhen, da innerhalb der Fixierungsglasurmasse 20 ein Verkeilungseffekt erreicht wird, wodurch sich die maximale Auszugskraft der Anschlußdrähte 16 in axialer Richtung aus dem Kontaktbereich 18 deutlich erhöht.

Die erfindungsgemäße Anordnung des Sensorbauelementstruktur und insbesondere des Kontaktbereichs wird erreicht, indem während der Herstellung der Sensors, d. h. nachdem ein Metallfilm 14 auf den Keramikträger 12 aufgebracht wurde, Vertiefungen bzw. Stufen 24 in den Keramikträger 12 gesägt werden, wobei an diesen Stellen gleichzeitig auch der Metallfilm 14 entfernt wird.

Diese Vertiefungen 24 werden mit einer geeigneten Glasmasse wieder aufgefüllt, wobei auch die Fixierungsglasurmasse 20 zum Füllen der Vertiefungen 24 verwendet werden kann. Nachdem die Anschlußdrähte 16 an den vorgesehenen Kontaktflächen des Metallfilms 14 angebondet werden, werden diese wiederum mit einer Fixierungsglasurmasse umgeben und bei einer hohen Temperatur aufgeschmolzen. Die Fixierungsglasurmasse 20 verschmilzt hierbei zusätzlich zur Verbindung mit dem Metallfilm 14 auch mit der in den Vertiefungen 24 seitlich daneben angeordneten Glasmasse zu einer einheitlichen Fixierung für die Anschlußdrähte 16.

Diese Glasmasse kann sowohl durch die Fixierungsglasur 20 gebildet werden, die sich im flüssigen Zustand während des Aufbringens auf den Kontaktbereich 18 und während der Verschmelzung mit dem Keramikträger 12 in die Vertiefungen 24 in dem Keramikträger 12 ausbreitet, als auch ferner getrennt zu der Fixierungsglasurmasse 20 vor der Verschmelzung mit derselben in den Vertiefungen 24 aufgebracht werden.

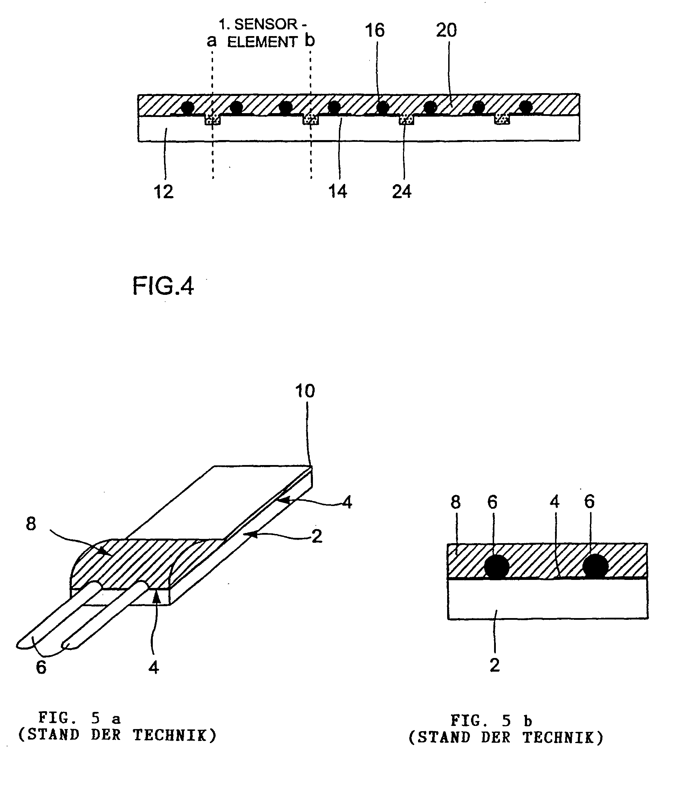

In Figur 4 ist die Anordnung einer Sensorbauelementereihe während des oben beschriebenen Herstellungsverfahren dargestellt, bevor die Reihe an den Trennlinien a, b, usw. in einzelne Sensorbauelemente zertrennt wird.

## Patentansprüche

1. Sensorbauelement mit
einem Keramikträger (12);
einem Metallfilm (14), der auf dem Keramikträger (12) aufgebracht ist;
zumindest einem Anschlußdraht (16), der in einem Kontaktbereich (18) mit dem Metallfilm elektrisch verbunden ist;
einer Fixierungsglasur (20), die in dem Kontaktbereich (18) über dem Metallfilm (14) und dem zumindest einen Anschlußdraht (16) aufgebracht ist;
**dadurch gekennzeichnet, daß**
der Keramikträger (12) im Bereich der Fixierungsglasur (20) zumindest eine Vertiefung (24) aufweist.

2. Sensorbauelement gemäß Anspruch 1, **dadurch gekennzeichnet, daß** die zumindest eine Vertiefung (24) mit einer Glasmasse gefüllt ist, die sowohl mit dem Keramikträger (12) als auch mit der Fixierungsglasur (20) fest verbunden ist.

3. Sensorbauelement gemäß Anspruch 1 oder 2, **gekennzeichnet durch** eine Glaspassivierungsschicht (22), die über dem Metallfilm (14) außerhalb des Kontaktbereichs (18) aufgebracht ist.

4. Sensorbauelement gemäß einem der Ansprüche 1 bis 3, **dadurch gekennzeichnet, daß** der Metallfilm (14) eine kammartige Struktur aufweist, in der Keramikträgerbereiche freigelegt sind, wobei die freigelegten Keramikträgerbereiche fest mit der Fixierungsglasur (20) verbunden sind.

5. Sensorbauelement gemäß einem der Ansprüche 1 bis 4, **dadurch gekennzeichnet, daß** sich der Querschnitt des zumindest einen Anschlußdrahts (16) innerhalb der Fixierungsglasur in der dem Keramikträger (12) zugewandten Erstreckungsrichtung des Anschlußdrahts (16) verbreitert.

6. Sensorbauelement gemäß einem der Ansprüche 1 bis 5, **dadurch gekennzeichnet, daß** der Metallfilm aus Platin oder Nickel besteht.

7. Sensorbauelement gemäß einem der Ansprüche 1 bis 6, **dadurch gekennzeichnet, daß** das Keramikträgermaterial aus einem Al₂O₃-Keramikmaterial oder einem MgTiO₃-Keramikmaterial besteht.

8. Verfahren zum Herstellen eines Sensorbauelements mit folgenden Schritten:
Aufbringen eines Metallfilms (14) auf einem Keramikträger (12);
Vorsehen von zumindest einer Vertiefung (24) in dem Keramikträger (12);
elektrisches Verbinden des Metallfilms (14) mit zumindest einem Anschlußdraht (16) in einem Kontaktbereich (18);
Aufbringen einer Fixierungsglasurmasse (20) in dem Kontaktbereich (18) über dem Anschlußdraht (16), dem Metallfilm (14) und der zumindest einen Vertiefung (24); und
Verschmelzen der Fixierungsglasurmasse (20) mit dem Keramikträger (12).

9. Verfahren nach Anspruch 8, mit folgenden Schritten:
Auffüllen der zumindest einen Vertiefung (24) mit einer Glasmasse nach dem Schritt des Vorsehens der Vertiefung (24);
Aufbringen einer Glaspassivierungsschicht (22) auf dem Metallfilm außerhalb des Kontaktbereichs (18) nach dem Schritt des Aufbringens der Fixierungsglasurmasse (20),
wobei der Schritt des Verschmelzens das Verschmelzen der Glasmasse in der zumindest einen Vertiefung mit dem Keramikträger (12) und der Fixierungsglasurmasse (20) umfaßt.

10. Verfahren zum Herstellen eines Sensorbauelements nach Anspruch 8 oder 9, mit folgenden Schritten:
Herstellen der kammartigen Struktur des Metallfilms durch Laserbestrahlung oder Plasmaätzen;
Vorsehen der zumindest einen Vertiefung (24) durch Sägen der Vertiefungen (24) in das Keramikträgermaterial (12).

## Claims

1. A sensor component comprising
a ceramic support (12);
a metal film (14) applied to said ceramic support (12);
at least one connecting wire (16) electrically connected to the metal film (14) in a contact area (18);
a fixing glaze (20) applied to the metal film (14) and the at least one connecting wire (16) in the contact area (18);
**characterized in that**
the ceramic support (12) has at least one recess (24) in the area of the fixing glaze (20).

2. A sensor component according to claim 1, **characterized in that** the at least one recess (24) is filled with a glass composition which is fixedly connected both to the ceramic support (12) and to the fixing glaze (20).

3. A sensor component according to claim 1 or 2, **characterized by** a glass passivation layer (22) which is applied on top of the metal film (14) outside of the contact area (18).

4. A sensor component according to one of the claims 1 to 3, **characterized in that** the metal film (14) has a comblike structure in which ceramic support areas are exposed, the exposed ceramic support areas being fixedly connected to the fixing glaze (20).

5. A sensor component according to one of the claims 1 to 4, **characterized in that** the cross-section of the at least one connecting wire (16) widens within the fixing glaze in the connecting wire direction facing the ceramic support (12).

6. A sensor component according to one of the claims 1 to 5, **characterized in that** the metal film consists of platinum or nickel.

7. A sensor component according to one of the claims 1 to 6, **characterized in that** the ceramic-support material consists of an Al₂O₃ ceramic material or an MgTiO₃ ceramic material.

8. A method of producing a sensor component comprising the following steps:
applying a metal film (14) to a ceramic support (12) ;
providing at least one recess (24) in said ceramic support (12);
electrically connecting the metal film (14) to at least one connecting wire (16) in a contact area (18);
applying a fixing glaze composition (20) to the connecting wire (16), the metal film (14) and the at least one recess (24) in the contact area (18), and
fusing the fixing glaze composition (20) to the ceramic support (12).

9. A method according to claim 8 comprising:
filling the at least one recess (24) with a glass composition after the step of providing said recess (24);
applying a glass passivation layer (22) to the metal film outside of the contact area (18) after the step of applying the fixing glaze composition (20),
the fusion step comprising the fusing of the glass composition in the at least one recess with the ceramic support (12) and the fixing glaze composition (20).

10. A method of producing a sensor component according to claim 8 or 9, comprising the following steps:
producing a comblike structure of the metal film by laser irradiation or plasma etching;
providing the at least one recess (24) by sawing said recesses (24) into the ceramic support material (12).

## Revendications

1. Composant détecteur comportant
un support céramique (12) ;
un film métallique (14) qui est appliqué sur le support céramique (12) ;
au moins un conducteur de raccordement (16) qui est électriquement relié au film métallique dans une zone de contact (18) ;
une glaçure de fixation (20) qui est appliquée, dans la zone de contact (18), par dessus le film métallique (14) et le conducteur de raccordement (16) dont il y a au moins un ;
**caractérisé par le fait**
**que** le support céramique (12) présente dans la zone de la glaçure de fixation (20), au moins un évidement (24).

2. Composant détecteur selon la revendication 1, **caractérisé par le fait que** l'évidement (24) dont il y a au moins un est rempli d'une masse vitreuse qui est solidarisée aussi bien avec le support métallique (12) qu'avec la glaçure de fixation (20).

3. Composant détecteur selon la revendication 1 ou 2, **caractérisé par** une couche de passivation en verre (22) qui est appliquée par dessus le film métallique (14) à l'extérieur de la zone de contact (18).

4. Composant détecteur selon l'une des revendications 1 à 3, **caractérisé par le fait que** le film métallique (14) présente une structure en peigne dans laquelle des zones du support céramique sont dégagées, les zones du support céramique dégagées étant solidarisées avec la glaçure de fixation (20).

5. Composant détecteur selon l'une des revendications 1 à 4, **caractérisé par le fait que** la section du conducteur de raccordement (16) dont il y a au moins un s'élargit à l'intérieur de la glaçure de fixation selon la direction de l'extension du conducteur de raccordement (16) orientée vers le support céramique (12).

6. Composant détecteur selon l'une des revendications 1 à 5, **caractérisé par le fait que** le film métallique est constitué de platine ou de nickel.

7. Composant détecteur selon l'une des revendications 1 à 6, **caractérisé par le fait que** le matériau du support céramique est constitué d'un matériau céramique du type Al₂O₃ ou d'un matériau céramique du type MgTiO₃.

8. Procédé de fabrication d'un composant détecteur comportant les pas suivants :
appliquer un film métallique (14) sur un support céramique (12);
prévoir au moins un évidement (24) dans le support céramique (12) ;
réaliser une liaison électrique du film métallique (14) avec au moins un conducteur de raccordement (16) dans une zone de contact (18) ;
appliquer une masse de glaçure de fixation (20) dans la zone de contact (18) par dessus le conducteur de raccordement (16), le film métallique (14) et l'évidement (24) dont il y a au moins un ; et
faire fondre la masse de glaçure de fixation (20) avec le support céramique (12).

9. Procédé selon la revendication 8, comportant les pas suivants :
remplir l'évidement (24) dont il y a au moins un d'une masse vitreuse après le pas de prévision de l'évidement (24) ;
appliquer une couche de passivation en verre (22) sous le film métallique à l'extérieur de la zone de contact (18) après le pas de l'application de la masse de glaçure de fixation (20),
dans lequel le pas de la fusion comporte la fusion de la masse vitreuse dans l'évidemment, dont il y a au moins, avec le support céramique (12) et la masse de glaçure de fixation (20).

10. Procédé de fabrication d'un composant détecteur selon la revendication 8 ou 9, comportant les pas suivants :
fabriquer la structure en peigne du film métallique par irradiation au laser ou attaque au plasma ;
prévoir l'évidement dont il y a au moins en sciant les évidements (24) dans le matériau du support céramique (12).
